# EUROPEAN PATENT SPECIFICATION

(11) **EP 2 071 632 B1**
(45) Date of publication and mention of the grant of the patent: **27.02.2013**
(21) Application number: 07024276.3
(22) Date of filing: 14.12.2007
(51) Int. Cl.: H01L 31/0224, H01L 31/18

(54) **Thin-film solar cell and process for its manufacture**
Dünnfilmsolarzelle und Verfahren zu ihrer Herstellung
Cellule solaire à couche mince et son procédé de fabrication

(43) Date of publication of application: 17.06.2009
(73) Proprietor: Fraunhofer-Gesellschaft zur Förderung der angewandten Forschung e.V., 80686 München (DE)
(72) Inventor: Mitchell, Emily, 79110 Freiburg (DE); Reber, Stefan, 79194 Gundelfingen (DE); Schmich, Evelyn, 77652 Offenburg (DE)
(74) Representative: Pfenning, Meinig & Partner GbR

(56) References cited:
- WO-A-2006/029250
- US-A- 6 143 976
- US-A1- 2004 261 839
- US-A1- 2004 261 840
- US-A1- 2005 172 996
- US-A1- 2006 060 238
- JOOSS W ET AL: "Process and technology development for back contact silicon solar cells", CONFERENCE RECORD OF THE IEEE PHOTOVOLTAIC SPECIALISTS CONFERENCE 2002 INSTITUTE OF ELECTRICAL AND ELECTRONICS ENGINEERS INC. US; [IEEE PHOTOVOLTAIC SPECIALISTS CONFERENCE],, vol. CONF. 29, 19 May 2002 (2002-05-19), pages 122-125, XP010666250, DOI: 10.1109/PVSC.2002.1190471 ISBN: 978-0-7803-7471-3
- NOT PROCESSED: "Not processed", 21ST EUROPEAN PHOTOVOLTAIC SOLAR ENERGY CONFERENCE : PROCEEDINGS OF THE INTERNATIONAL CONFERENCE HELD IN DRESDEN, GERMANY, 4 - 8 SEPTEMBER 2006, WIP RENEWABLE ENERGIES, MÜNCHEN, 4 September 2006 (2006-09-04), XP040512492, ISBN: 978-3-936338-20-1
- AIKEN D J ET AL: "Thin, substrate-based crystalline silicon solar cells with no grid shading", CONFERENCE RECORD OF THE 26TH IEEE PHOTOVOLTAIC SPECIALISTS CONFERENCE 19970929; 19970929 - 19971003 NEW YORK, NY : IEEE, US, 29 September 1997 (1997-09-29), pages 763-766, XP010267897, DOI: 10.1109/PVSC.1997.654201 ISBN: 978-0-7803-3767-1
- WILLEKE G P ED - INSTITUTE OF ELECTRICAL AND ELECTRONICS ENGINEERS: "The Fraunhofer ISE roadmap for crystalline silicon solar cell technology", CONFERENCE RECORD OF THE IEEE PHOTOVOLTAIC SPECIALISTS CONFERENCE 2002 INSTITUTE OF ELECTRICAL AND ELECTRONICS ENGINEERS INC. US; [IEEE PHOTOVOLTAIC SPECIALISTS CONFERENCE],, vol. CONF. 29, 19 May 2002 (2002-05-19), pages 53-57, XP010666236, DOI: 10.1109/PVSC.2002.1190454 ISBN: 978-0-7803-7471-3

## Description

The present invention refers to a thin-film solar cell which is contacted from the rear-side. The invention is based on a combination of thin-film solar cells, e.g. wafer equivalents, with the emitter wrap-through (EWT) technology. The present invention also provides a process for manufacturing these solar cells.

The development of thin-film solar cells is known from the prior art for years. The idea is to use a low-cost substrate to save material costs. The solar cell is deposited onto a substrate, e.g. epitaxially with silicon, and the resultant structure can be similar to a standard wafer solar cell.

In the prior art, three types of thin-film solar cells exist in dependence of the type of substrate used.

The first type of substrate is glass, which is popular since it can serve the double purpose of cell encapsulation. However, glass softens at temperatures between 600 and 700 °C making glass only usable for low-temperature cell processing. In general, these cells use transparent conducting oxides (TCOs) as front-side contact.

A second type of substrates used for thin-film solar cells are high-temperature substrates, such as ceramics or low-grade silicon making these substrates processable in high-temperature processing. Thus, much higher cell efficiencies can be reached. As the substrate is not transparent, the front of the cell, i.e. where the light enters, must be the thin-film side of the substrate. In this configuration, the cell resembles a wafer solar cell, hence the name "wafer equivalent".

For a third type of thin-film solar cell, the thin-film is grown on a high-temperature substrate and subsequently transferred to a low-temperature substrate, e.g. glass.

The background of another aspect of the present invention refers to the emitter wrap-through (EWT) technology which was published for the first time in Gee, J. M., W. K. Schubert, et al. (1993), Emitter-wrap-through solar cell. Proceedings of the 23rd IEEE Photovoltaics Specialists Conference, Louisville, Kentucky, USA, IEEE; New York, NY, USA. The EWT cell concept involves making via holes through the substrate and extending the emitter layer through these holes so that it can be contacted from the rear-side. The base contact must also still be contacted from the rear-side so an interdigitated contact pattern is formed. Various process techniques have been applied to create the rear contact pattern including diffusion barriers and screen printing, laser defined and plated contacts and phosphorous aluminium codiffusion.

W. Jooss et al "Process and technology development for back contact silicon solar cells" IEEE Photovoltaic specialist conference 29, p. 122-125, XP010666250 (2002) discloses technology for back contact solar cells. G Beaucarne et al., 21st European Photovoltaic Solar Energy Conference, 4 - 8 September 2006, Dresden, Germany sketches future scenarios in photovoltaics.

Presently, many research groups are developing techniques for the fabrication of EWT solar cells. Some topics of focus in the published work are the various metallisation techniques, e.g. photolithography, electroless plating or screen-printing, the various rear-side structuring techniques, e.g. laser definition or Al-P codiffusion, rear-side passivation, increasing the rear-side emitter coverage and cell modelling. The vast majority of the EWT technology relates to standard silicon wafer solar cells. One concept of EWT cells is described in Thorp, D. (1998), A Low-temperature Deposited-silicon Selective-emitter-wrap-through Si Solar Cell, Proceedings of the 2nd World Conference on Photovoltaic Energy Conversion, Vienna, Austria, European Commission, Ispra, Italy, 1998, based on a standard silicon wafer EWT cell. Silicon layers were deposited at low temperature therein-through via holes from the rear-side as contact layers. A single metal layer was applied and then scribed with a laser to form the interdigitated pattern. An additional dielectric layer was used to protect the substrate since the substrate was not damageable.

It is an advantage that some thin-film solar cells can be metallized with the standard wafer solar cell metallization techniques. However, there is an industrial trend towards rear-side contacting because it has several benefits: There is no shading from the metal contact grid; the emitter can be optimized for the blue response; the contacts can be optimized for low series resistance; module fabrication is simpler and cells can more densely be packed in a module.

Therefore, the technical problem of the present invention was to provide solar cells eliminating the drawbacks of the mentioned solar cells having a high efficiency and to provide a process for their manufacture which is easy to handle and is based on existing process technologies.

This technical problem is solved by the solar cell with the features of claim 1 and the process having the features of claim 13. The further dependent claims refer to further embodiments.

According to the present invention, a thin-film solar cell with a front-side, i.e. where the light enters, and a rear-side is provided having the following components:
- a non-solar-grade substrate having at least one via hole connecting the front-side with the rear-side;
- at least one photovoltaically active base layer deposited on the substrate and at least one emitter layer formed at least in regions of the front-side and wrapped through said via hole from the front-side to the rear-side providing an emitter wrap-through (EWT) contact; and
- at least one emitter contact region and at least one base contact region on the rear-side insulated from each other.

Preferably, the fraction of the rear-side which is covered by the emitter layer is minimised or eliminated.

Thus, a solar cell has been provided for the first time based on a low-cost substantially photovoltaically inactive substrate on which at least one photovoltaically active base is deposited and emitter layers are formed which are wrapped through via holes contacting the solar cell from the rear-side.

Preferably, at least one isolation layer is deposited between the contact region and the base layer and/or the substrate.

It is preferred that the solar cell on its front-side further comprises a passivating layer which preferably is deposited on the emitter layer. This layer further preferably has anti-reflective properties and preferably consists of a dielectric material, e.g. silicon dioxide, silicon carbide, silicon nitride or mixtures thereof.

A first inventive solar cell concept is based on an electrically conductive material, which preferably is doped silicon, e.g. non-solar grade silicon with a low minority-carrier lifetime. In that case, the substrate acts as a conduction path to the base region, i.e. the base layer. It is necessary that the conductive substrate has to be masked from the emitter contact region which is located on the rear-side of the solar cell. Therefore, preferably an insulating layer is used for the separation of conductive substrate and emitter contact region. Such an insulating layer can be deposited before the formation of the via holes as well as after the deposition of the base and emitter layers on the substrate.

A second inventive concept is based on an electrically non-conductive, i.e. insulating substrate. Also comprised by this concept is a solar cell embodiment having an insulating intermediate layer between substrate and base and emitter layers. Although the substrate cannot be used to conduct the base current, it is possible to wrap the base layers entirely around the substrate while the emitter layer is not wrapped around entirely or has at least one region, preferably on the rear-side, which is free of an emitter layer.

The photovoltaically active material is preferably a semiconductor, in particular a group IV semiconductor, a group III/V semiconductor or a group II/VI semiconductor, e.g. silicon, GaAs and CdTe are preferred.

According to the present invention, also a process for the manufacture of a thin-film solar cell is provided. This process comprises the following steps:
a) Depositing at least one photovoltaically active base layer and forming at least one emitter layer on a non-solar grade substrate having via holes, wherein the layers are applied on the front-side surface, in the via holes and partially on the rear-side of the substrate;
b) Depositing at least one isolation layer on the rear-side of the substrate, covering the entire rear-surface but not covering the entire inner surface of the holes; and
c) Forming at least one emitter contact region and at least one base contact region on the rear-side insulated from each other.

It is further preferred that the at least one emitter contact region and the at least one base contact region at the rear-side of the solar cell are formed from one continuous, electrically conductive layer which is entirely deposited on the rear-side. This layer is subsequently structured, e.g. by a laser, in said emitter and base contact regions.

It is a further option that the deposition of the photovoltaically active base layer and the emitter layer is performed from the gas phase, e.g. by chemical vapour deposition, possibly epitaxially.

Preferably, a passivation layer is deposited on the front-side subsequent to step a). This passivation layer preferably consists of a dielectric material and is anti-reflective. However, the passivation layer can also be deposited on the front-side of the solar cell subsequent to step c).

A preferred embodiment refers to the deposition of the base and emitter layers in-situ as complete pn-structure. However, it is also possible to deposit the base layer in step a) and forming the emitter layer subsequently by diffusion.

The present invention is further explained by the following figures which show special embodiments which shall not limit the present invention to these embodiments.

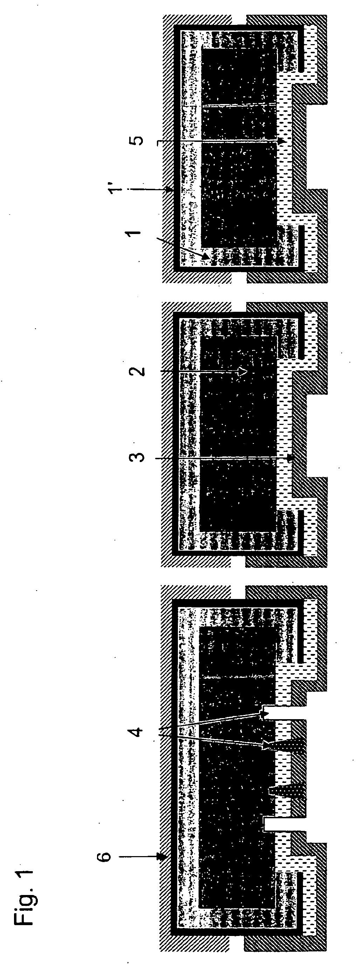

Fig. 1 to 9 show cross-sectional views of different inventive embodiments of the present invention.

Fig. 1 shows a first embodiment of the inventive solar cell in a cross-sectional view.

Both the base layer 1 and the emitter layer 1' of the solar cell are wrapped through the via holes in the low-cost substrate 2. This is achieved by depositing the layers of the solar cell simultaneously over the front surface of the substrate and directly into the holes. The substrate may be highly doped and highly conductive. Therefore, it can be used to conduct current laterally to the base contacts, allowing more flexibility with the design of the interdigitated contact. It is also possible to use an insulating substrate in which case the deposited base must be used for conduction. The rear surface of the substrate can be damaged without lowering the efficiency of the solar cell which greatly simplifies the definition of the interdigitated contact pattern. Metal 3 can be deposited over the entire rear surface and then the base and emitter contact regions can be isolated with a laser 4. This is essentially a self-aligning process because the regions must only be aligned to the pre-drilled holes and a large tolerance is allowed. Further layers shown in Fig. 1 are the isolating dielectric layer 5 and the passivating anti-reflection coating 6.

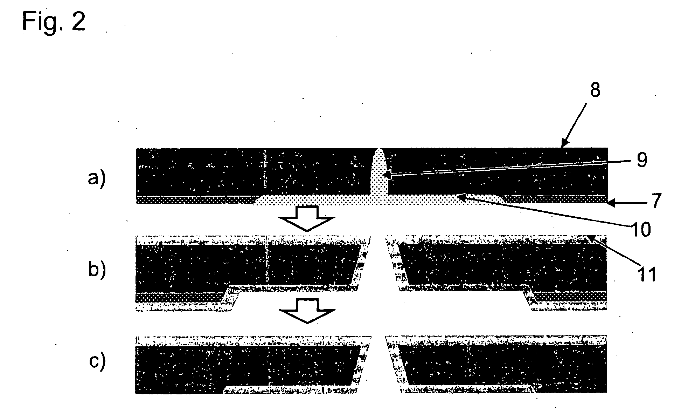

Fig. 2 shows schematically the steps for producing the inventive solar cells. In a first step (Fig. 2a), a dielectric layer 7 is applied to the rear surface of the substrate 8. A narrow via hole 9 having a diameter between 50 and 100 µm is drilled by laser in the substrate 8. Furthermore, circles 10 with a diameter of about 300 µm are ablated with a laser. The dielectric layer 7, e.g. a layer of PECVD-SiO₂, can act as an etch mask during the via laser-damage etch. The second step (Fig. 2b) refers to an epitaxial deposition of the photovoltaically active layer 11 on the front-side and the rear-side as well as the via hole surfaces of the substrate. Fig. 2c) shows a lift-off process by under-etching the dielectric layer 7.

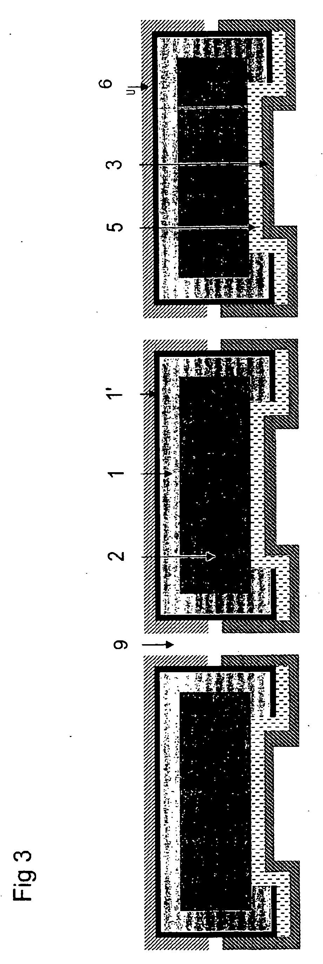

Fig. 3 depicts a further embodiment of the inventive solar cell having a conductive substrate in cross-section. If the substrate is conductive, e.g. heavily p-type doped low-grade silicon, then it acts as a conduction path to the base region. Therefore, the substrate must be masked from the emitter metal contact which is deposited over the entire rear surface. For that purpose, an insulating layer, e.g. possible silicon carbide is used, which is either deposited before the via holes are formed or after the solar cell deposition. The holes 10 are formed in the conductive low-cost substrate 2. The solar cell base layer 1 and emitter layer 1' are deposited consecutively in a single deposition process, e.g. epitaxy. An insulating film 5, e.g. silicon carbide, is deposited before the metal emitter contact layer 3, e.g. evaporated or screen-printed aluminium, is formed over the entire rear surface and partially through the holes. If the insulating film is deposited before the hole formation then an extra rear-side emitter diffusion step, e.g. phosphorous, may be required after the solar cell deposition to prevent shunting.

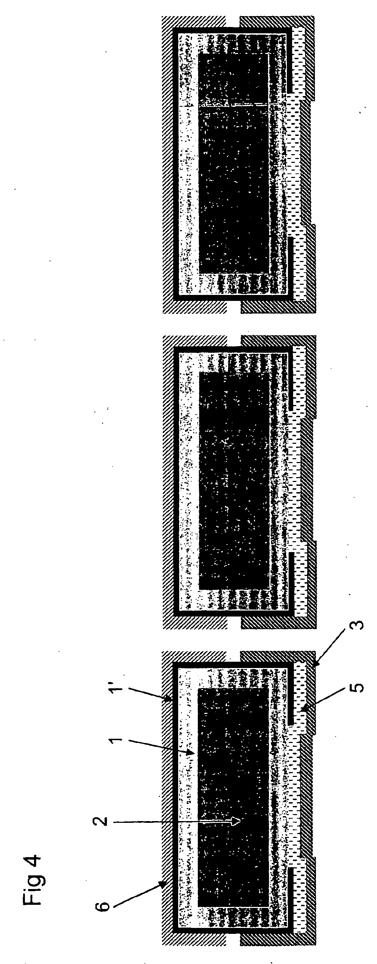

Fig. 4 is an illustration of a further embodiment having an insulating substrate. If the substrate is non-conductive or if an isolating intermediate layer between substrate and solar cell layers is present, then it cannot be used to conduct the base current. It is still possible to realize the cell concept if the deposited solar cell base wraps entirely around the substrate but the deposited emitter does not, or is partially removed after deposition. The only difference is that both the emitter and base currents are conducted laterally through the layers and down through the via holes. A low resistance conduction path can be created in the base layer with a back-surface field (BSF).

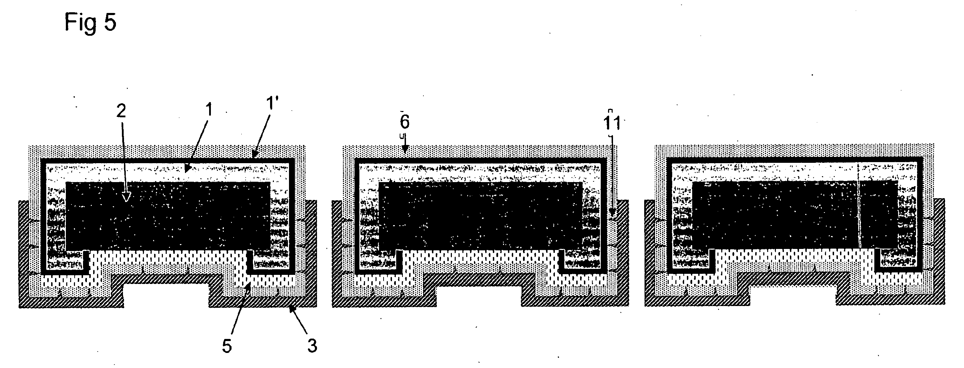

Fig. 5 shows a cross-section of an inventive solar cell having a passivated front surface. Passivation of the front surface of the solar cell can be achieved by depositing a dielectric film, e.g. silicon nitride as shown in Fig. 3. This film can either be deposited directly after the solar cell deposition process or after the rear metallization. The order of the steps constitutes a trade-off between passivation quality and contact resistance. Alternatively, passivation can be achieved with the growth of a dielectric layer 6, e.g. thermal oxide. The dielectric layer 6 is grown after the insulator deposition and solar cell deposition steps, regardless of their order (insulator first is depicted here). A metal layer 3 is formed over the rear surface and partially through the holes. This metal makes contact to the emitter at points where it spikes through the dielectric layer 11.

After passivation is achieved and the emitter contact is made, the next step is to create the base contact. The shape of the rear contact pattern depends on the conductivity of the substrate. If a non-conductive substrate is used, then a fully interdigitated pattern with evenly spaced (approximately 1 mm pitch) base and emitter contact fingers will be necessary. If the substrate is conductive, then it is possible to have less base contact fingers. In this case, the via hole spacing can be optimized within the wide (up to a few centimeters) emitter contact fingers. The few base contact fingers must be thickened, e.g. with electro-plating, to enable conduction of the relatively high currents. All diagrams here show contact structures for conductive substrates.

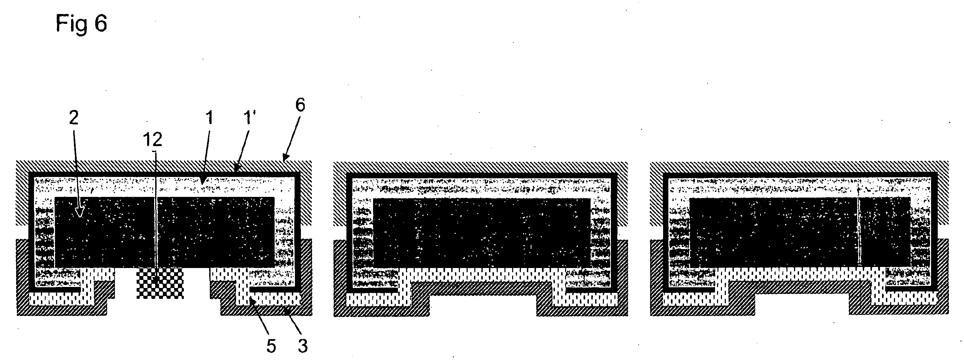

To get access to the base, areas of the emitter contact need to be removed, by masked etching for example (Fig. 6). Then the base contact metal 12 must be formed by an aligned process, e.g. screen printing or masked evaporation.

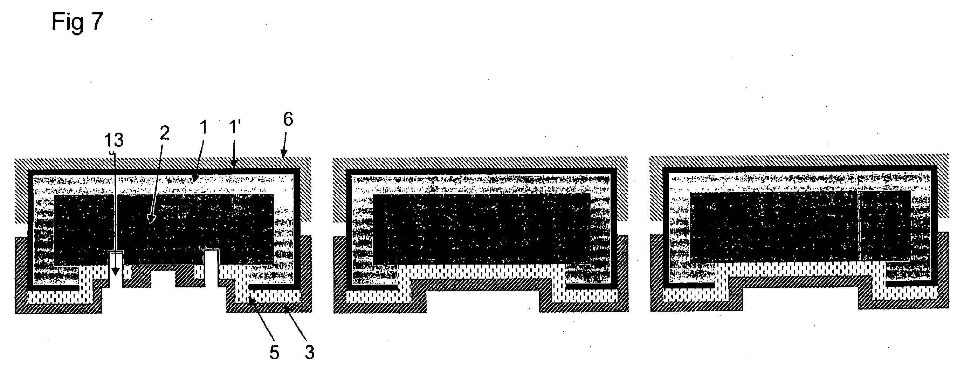

Alternatively, if the insulating layer had been partially removed, e.g. by laser ablation, in the base contact regions prior to the formation of the emitter metal contact (Fig. 7), then the base contact region could subsequently be isolated with trenches, e.g. laser scribes 13.

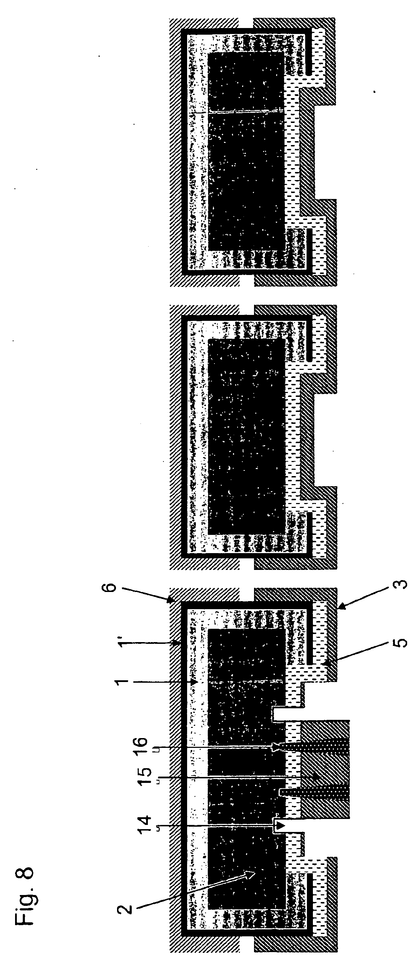

The rear contact pattern can also be defined using a self-aligned process, which is a significant simplification (Fig. 8). Laser trenches are scribed to isolate the base contact region from the emitter contact 14. If the base contact fingers are widely spaced then, they must be thickened to reduce series resistance 15. Then, this metal region is connected to the substrate by laser-fired contacts 16 which are points (or lines, or an area) where a laser is used to melt through the insulating layer.

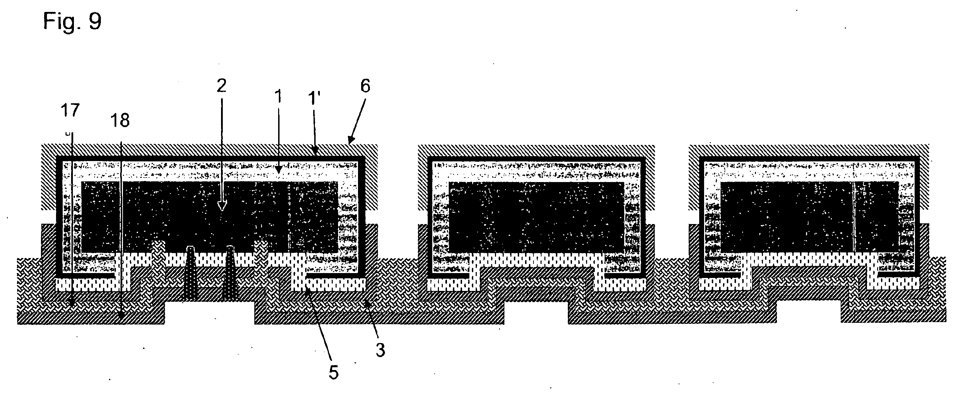

There is a different method which avoids thickening the contact fingers (Fig. 9). After the laser trenches are formed, a resistive layer 17 is deposited followed by another layer of metal 18. Laser-fired contacts connect this second metal layer to the substrate and so it becomes the base contact. There must be a strip at one edge of the solar cell without the resistive layer or the second layer of metal, e.g. formed by masking, to enable access to the emitter contact for cell interconnection purposes.

The further reference signs of figures 4 to 9 correspond to those of fig. 3.

## Claims

1. Thin-film solar cell with a front-side where the light enters and a rear-side having
• a non-solar grade substrate (2) having at least one via hole (9) connecting the front-side with the rear-side;
• at least one photovoltaically active deposited base layer (1) and at least one emitter layer (1') formed at least in regions of the front-side and wrapped through said via hole from the front-side to the rear-side providing an emitter wrap-through (EWT) contact; and
• at least one emitter contact region (3) and at least one base contact region on the rear-side insulated from each other.

2. Solar cell of claim 1,
wherein the fraction of the rear-side which is covered by the emitter layer is minimised or eliminated.

3. Solar cell of claims 1 or 2,
wherein the rear-side is able to be damaged without detriment to the cell performance.

4. Solar cell of any of claims 1 to 3,
wherein the substrate is substantially photovoltaically inactive.

5. Solar cell of any of claims 1 to 4,
wherein at least one isolation layer (5) is deposited between the contact region and the base layer and/or the substrate.

6. Solar cell of any of claims 1 to 5,
wherein the solar cell on the front-side further comprises a passivating layer (6) deposited on the emitter layer.

7. Solar cell of any of claims 1 to 6,
wherein the passivating layer is anti-reflective and consists of a dielectric material.

8. Solar cell of claim 7,
wherein the dielectric material is selected from the group consisting of silicon oxide, silicon carbide, silicon nitride and mixtures thereof.

9. Solar cell of claim 8,
wherein the substrate is an electrically conductive material, preferably a doped silicon.

10. Solar cell of any of claims 1 to 9,
wherein the substrate is an electrically insulating material and at least one electrically conductive layer, which is wrapped around said substrate entirely while the emitter layer is not wrapped around entirely having at least one region which is free of an emitter layer.

11. Solar cell of any of the preceding claims,
wherein the at least one emitter contact region and at least one base contact region on the rear-side are formed from one continuous electrically conductive layer which is subsequently structured in said regions.

12. Solar cell of any of the preceding claims,
wherein the photovoltaically active material is a semiconductor, in particular a group IV semiconductor, group III/V semiconductor and group II/VI semiconductor, preferably selected from the group consisting of silicon, GaAs and CdTe.

13. Process for the manufacture of a thin-film solar cell having the following steps:
a) Depositing or growing at least one photovoltaically active base layer (11) and forming at least one emitter layer (1') on a non-solar grade substrate (2) having via holes (9), wherein the layers are applied on the front-side surface, in the via holes and partially on the rear-side of the substrate;
b) Depositing at least one isolation layer (5) on the entire rear-side of the substrate; and
c) Forming at least one emitter contact region and at least one base contact region on the rear-side insulated from each other.

14. Process of claim 13,
wherein in step c) at least one metal layer is formed on the rear-side and the metal layer is structured into at least one emitter contact region and at least one base contact region insulated from each other.

15. Process of any of claims 13 or 14,
wherein the deposition in step a) is a chemical vapour deposition, a physical vapour deposition, a liquid phase epitaxy and/or an evaporation.

16. Process of any of claims 13 to 15,
wherein the growing is an epitaxial layer growth.

17. Process of any of claims 13 to 16,
wherein a passivation layer (6) is deposited on the front-side subsequent to step a).

18. Process of any of claims 13 to 16,
wherein a passivation layer is deposited on the front-side subsequent to step c).

19. Process of any of claims 13 to 18,
wherein an electrically conductive substrate is used.

20. Process of any of claims 13 to 18,
wherein a electrically insulating substrate is used.

21. Process of any of claims 13 to 20,
wherein in step a) the at least one base layer is deposited and subsequently the at least one emitter layer is formed by diffusion.

22. Process of any of claims 13 to 20,
wherein in step a) the at least one base layer and the at least one emitter layer are deposited in-situ.

## Patentansprüche

1. Dünnschicht-Solarzelle mit einer Frontseite, wo das Licht eintritt und einer Rückseite mit
• einem Nicht-Solargrad-Substrat (2)
• mit mindestens einer Bohrung (9), die die Frontseite mit der Rückseite verbindet;
• mindestens eine photovoltaisch aktive, abgeschiedene Basisschicht (1) und mindestens eine Emitterschicht (1'), die zumindest in Bereichen auf der Frontseite gebildet ist und sich durch die besagte Bohrung von der Frontseite zu der Rückseite zieht und damit einen EWT-Kontakt bereitstellt; und
• mindestens einen Emitterkontakt-Bereich (3) und mindestens einen Basiskontakt-Bereich auf der Rückseite, die isoliert voneinander sind.

2. Solarzelle nach Anspruch 1,
**dadurch gekennzeichnet, dass** der Anteil der Rückseite, der mit der Emitterschicht beschichtet ist, minimiert oder eliminiert ist.

3. Solarzelle nach Ansprüchen 1 oder 2,
**dadurch gekennzeichnet, dass** die Rückseite beschädigbar ist, ohne dass die Leistung der Zelle beeinträchtigt wird.

4. Solarzelle nach einem der Ansprüche 1 bis 3,
**dadurch gekennzeichnet, dass** das Substrat im Wesentlichen photovoltaisch inaktiv ist.

5. Solarzelle nach einem der Ansprüche 1 bis 4,
**dadurch gekennzeichnet, dass** mindestens eine Isolationsschicht (5) zwischen dem Kontaktbereich und der Basisschicht und/oder dem Substrat abgeschieden ist.

6. Solarzelle nach einem der Ansprüche 1 bis 5,
**dadurch gekennzeichnet, dass** die Solarzelle auf der Frontseite zusätzlich eine Passivierungsschicht (6), die auf der Emitterschicht abgeschieden ist, aufweist.

7. Solarzelle nach einem der Ansprüche 1 bis 6,
**dadurch gekennzeichnet, dass** die Passivierungsschicht anti-reflektiv ist und aus einem dielektrischen Material besteht.

8. Solarzelle nach Anspruch 7,
**dadurch gekennzeichnet, dass** das dielektrische Material ausgewählt ist aus der Gruppe bestehend aus Siliciumoxid, Siliciumcarbid, Siliciumnitrid und Mischungen hiervon.

9. Solarzelle nach Anspruch 8,
**dadurch gekennzeichnet, dass** das Substrat ein elektrisch leitendes Material ist, bevorzugt dotiertes Silicium.

10. Solarzelle nach einem der Ansprüche 1 bis 9,
**dadurch gekennzeichnet, dass** das Substrat ein elektrisch isolierendes Material ist und mindestens eine elektrisch leitfähige Schicht aufweist, die vollständig um das Substrat herumgezogen ist, während die Emitterschicht nicht vollständig herumgezogen ist, und die elektrisch leitfähige Schicht mindestens einen Bereich aufweist, der frei von einer Emitterschicht ist.

11. Solarzelle nach einem der vorhergehenden Ansprüche,
**dadurch gekennzeichnet, dass** der mindestens eine Emitterkontakt-Bereich und der mindestens eine Basiskontakt-Bereich auf der Rückseite aus einer kontinuierlichen elektrisch leitfähigen Schicht gebildet ist, die nachträglich in den besagten Bereichen strukturiert wurde.

12. Solarzelle nach einem der vorhergehenden Ansprüche,
**dadurch gekennzeichnet, dass** das photovoltaisch aktive Material ein Halbleiter ist, insbesondere ein Gruppe IV-Halbleiter, Gruppe III/V-Halbleiter und Gruppe II/VI-Halbleiter, bevorzugt ausgewählt aus der Gruppe bestehend aus Silicium, GaAs und CdTe.

13. Verfahren zur Herstellung einer Dünnschicht-Solarzelle mit den folgenden Schritten:
a) Abscheidung oder Aufwachsen mindestens einer photovoltaisch aktiven Basisschicht (1) und Bildung mindestens einer Emitterschicht (1') auf einem Nicht-Solargrad-Substrat (2) mit Bohrungen (9), wobei die Schichten auf der Frontseitenoberfläche, in den Bohrungen und teilweise auf der Rückseite des Substrats abgeschieden werden;
b) Abscheidung mindestens einer Isolationsschicht (5) auf der gesamten Rückseite des Substrats und
c) Bildung mindestens eines Emitterkontakt-Bereichs und mindestens eines Basiskontakt-Bereichs isoliert voneinander auf der Rückseite.

14. Verfahren nach Anspruch 13,
**dadurch gekennzeichnet, dass** in Schritt c) mindestens eine Metallschicht auf der Rückseite gebildet wird und die Metallschicht in mindestens einen Emitterkontakt-Bereich und mindestens einen Basiskontakt-Bereich, die voneinander isoliert sind, strukturiert wird.

15. Verfahren nach einem der Ansprüche 13 oder 14,
**dadurch gekennzeichnet, dass** die Abscheidung in Schritt a) eine chemische Gasphasenabscheidung, eine physikalische Gasphasenabscheidung, eine Flüssigphasen-Epitaxie und/oder eine Verdampfung ist.

16. Verfahren nach einem der Ansprüche 13 bis 15,
**dadurch gekennzeichnet, dass** das Aufwachsen ein epitaktisches Schichtwachstum ist.

17. Verfahren nach einem der Ansprüche 13 bis 16,
**dadurch gekennzeichnet, dass** eine Passivierungsschicht (6) nach Schritt a) auf der Frontseite abgeschieden wird.

18. Verfahren nach einem der Ansprüche 13 bis 16,
**dadurch gekennzeichnet, dass** eine Passivierungsschicht (6) nach Schritt c) auf der Frontseite abgeschieden wird.

19. Verfahren nach einem der Ansprüche 13 bis 18,
**dadurch gekennzeichnet, dass** ein elektrisch leitfähiges Substrat verwendet wird.

20. Verfahren nach einem der Ansprüche 13 bis 18,
**dadurch gekennzeichnet, dass** ein elektrisch isolierendes Substrat verwendet wird.

21. Verfahren nach einem der Ansprüche 13 bis 20,
**dadurch gekennzeichnet, dass** in Schritt a) die mindestens eine Basisschicht abgeschieden wird und anschließend die mindestens eine Emitterschicht durch Diffusion gebildet wird.

22. Verfahren nach einem der Ansprüche 13 bis 20,
**dadurch gekennzeichnet, dass** in Schritt a) die mindestens eine Basisschicht und die mindestens eine Emitterschicht in-situ abgeschieden werden.

## Revendications

1. Cellule solaire à couche mince dotée d'un côté avant à travers lequel la lumière pénètre et un côté arrière présentant :
- un substrat de qualité non solaire (2) ayant au moins un trou traversant (9) qui connecte le côté avant et le côté arrière ;
- au moins une couche de base déposée active de manière photovoltaïque (1) et au moins une couche d'émetteur (1') formée au moins dans des régions du côté avant et enroulée autour dudit trou traversant à partir du côté avant vers le côté arrière en fournissant un contact Emitter Wrap-Through (EWT) ; et
- au moins une région de contact d'émetteur (3) et au moins une région de contact de base sur le côté arrière isolées l'une de l'autre.

2. Cellule solaire selon la revendication 1,
dans laquelle la fraction du côté arrière qui est couverte par la couche d'émetteur est réduite au minimum ou éliminée.

3. Cellule solaire selon la revendication 1 ou 2,
dans laquelle le côté arrière peut être endommagé sans porter atteinte aux performances de la cellule.

4. Cellule solaire selon l'une quelconque des revendications 1 à 3,
dans laquelle le substrat est sensiblement inactif de manière photovoltaïque.

5. Cellule solaire selon l'une quelconque des revendications 1 à 4,
dans laquelle au moins une couche d'isolation (5) est déposée entre la région de contact et la couche de base et/ou le substrat.

6. Cellule solaire selon l'une quelconque des revendications 1 à 5,
dans laquelle la cellule solaire comprend en outre sur le côté avant une couche de passivation (6) déposée sur la couche d'émetteur.

7. Cellule solaire selon l'une quelconque des revendications 1 à 6,
dans laquelle la couche de passivation est antiréfléchissante et se compose d'un matériau diélectrique.

8. Cellule solaire selon la revendication 7,
dans laquelle le matériau diélectrique est choisi dans le groupe constitué d'oxyde de silicium, de carbure de silicium, de nitrure de silicium et de mélanges de ceux-ci.

9. Cellule solaire selon la revendication 8,
dans laquelle le substrat est un matériau électriquement conducteur, de préférence du silicium dopé.

10. Cellule solaire selon l'une quelconque des revendications 1 à 9,
dans laquelle le substrat est un matériau électriquement isolant et au moins une couche électriquement conductrice, qui est enroulée entièrement autour dudit substrat tandis que la couche d'émetteur n'est pas enroulée entièrement autour, présentant au moins une région exempte de couche d'émetteur.

11. Cellule solaire selon l'une quelconque des revendications précédentes,
dans laquelle la au moins une région de contact d'émetteur et au moins une région de contact de base sur le côté arrière, sont formées à partir d'une couche électriquement conductrice continue qui est structurée par la suite dans lesdites régions.

12. Cellule solaire selon l'une quelconque des revendications précédentes,
dans laquelle le matériau actif de manière photovoltaïque est un semi-conducteur, en particulier un semi-conducteur du groupe IV, un semi-conducteur du groupe III/V et un semi-conducteur du groupe II/VI, de préférence choisi dans le groupe constitué de silicium, GaAs et CdTe.

13. Procédé de fabrication d'une cellule solaire à couche mince présentant les étapes suivantes consistant à :
a) déposer ou tirer au moins une couche de base active de manière photovoltaïque (1) et former au moins une couche d'émetteur (1') sur un substrat de qualité non solaire (2) ayant des trous traversants (9), dans lequel les couches sont appliquées sur la surface du côté avant, dans les trous traversants et en partie sur le côté arrière du substrat ;
b) déposer au moins une couche d'isolation (5) sur tout le côté arrière du substrat ; et
c) former au moins une région de contact d'émetteur et au moins une région de contact de base sur le côté arrière isolées l'une de l'autre.

14. Procédé selon la revendication 13,
dans lequel, dans l'étape c), au moins une couche métallique est formée sur le côté arrière et la couche métallique est structurée dans au moins une région de contact d'émetteur et dans au moins une région de contact de base isolées l'une de l'autre.

15. Procédé selon la revendication 13 ou 14,
dans lequel le dépôt dans l'étape a) est un dépôt chimique en phase vapeur, un dépôt physique en phase vapeur, une épitaxie en phase liquide et/ou une évaporation.

16. Procédé selon l'une quelconque des revendications 13 à 15,
dans lequel le tirage est un tirage de couche épitaxiale.

17. Procédé selon l'une quelconque des revendications 13 à 16,
dans lequel une couche de passivation (6) est déposée sur le côté avant à la suite de l'étape a).

18. Procédé selon l'une quelconque des revendications 13 à 16,
dans lequel une couche de passivation est déposée sur le côté avant à la suite de l'étape c).

19. Procédé selon l'une quelconque des revendications 13 à 18,
dans lequel un substrat électriquement conducteur est utilisé.

20. Procédé selon l'une quelconque des revendications 13 à 18,
dans lequel un substrat électriquement isolant est utilisé.

21. Procédé selon l'une quelconque des revendications 13 à 20,
dans lequel, dans l'étape a), la au moins une couche de base est déposée et par la suite la au moins une couche d'émetteur est formée par diffusion.

22. Procédé selon l'une quelconque des revendications 13 à 20,
dans lequel, dans l'étape a), la au moins une couche de base et la au moins une couche d'émetteur sont déposées in situ.
